# EUROPEAN PATENT APPLICATION

(11) **EP 3 133 907 A1**
(43) Date of publication of application: **22.02.2017**
(21) Application number: 14889599.8
(22) Date of filing: 14.04.2014
(51) Int. Cl.: H05K 5/06

(54) **HOUSING**

(71) Applicant: Mitsubishi Electric Corporation, Chiyoda-ku Tokyo 100-8310 (JP)
(72) Inventor: KAWABE, Shin, Tokyo 100-8310 (JP); NIKI, Yuta, Tokyo 100-8310 (JP); TANAKA, Tetsuo, Tokyo 100-8310 (JP)
(74) Representative: Sajda, Wolf E.
(86) International application number: PCT/JP2014/060605
(87) International publication number: WO 2015/159339

(57) **Abstract**

A frame plate (14) forms a frame of an opening (20), and leads to side plates (12). On the frame plate (14), a spacer (9) extends towards the opening (20). The spacer (9) is folded back in the opening (20) in the side plate (12) directions, and is fixed to the inner surfaces of the side plates (12).

## Description

### Technical Field

The present invention relates to a housing.

### Background Art

A housing for outdoor use which has electronic equipment installed therein, for example, is usually provided with an opening to insert electronic equipment into the housing or to check inside the housing.

The housing is also hermetically sealed so that water, dust and the like do not enter the housing.

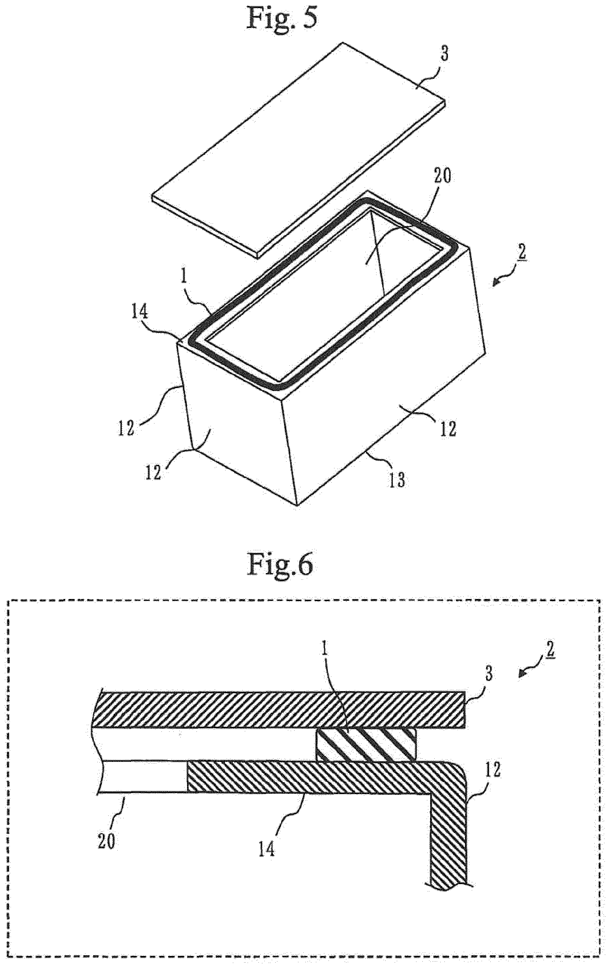

As illustrated in FIG. 5, as a structure to seal an opening 20 of a housing 2 which is formed from a metal plate, a structure having a packing (rubber) 1 mounted between a portion surrounding the opening 20 and a cover 3 to cover the opening 20 to compress the packing 1 by the housing 2 and the cover 3 is commonly used.

The packing 1 is mounted on a packing mounting surface of the housing 2 or of the cover 3 by using adhesive tape or the like.

The problem is that if the packing mounting surface is flat, the position of the packing 1 to be mounted cannot be defined, which causes the packing 1 to be mounted with a curve to produce a lot of different variations in manufacturing.

As illustrated in FIG. 6, there is a problem that the packing 1 is compressed excessively to cause degradation or cracking if the packing 1 is compressed between flat surfaces.

As a solution to those problems, there is a method of having a groove which is shallower in depth than the thickness of the packing 1, on the portion where the packing 1 is to be mounted, and fitting the packing 1 in the groove. With the housing 2 formed from a metal plate, however, it is difficult to provide the groove on the surface where the packing is to be mounted.

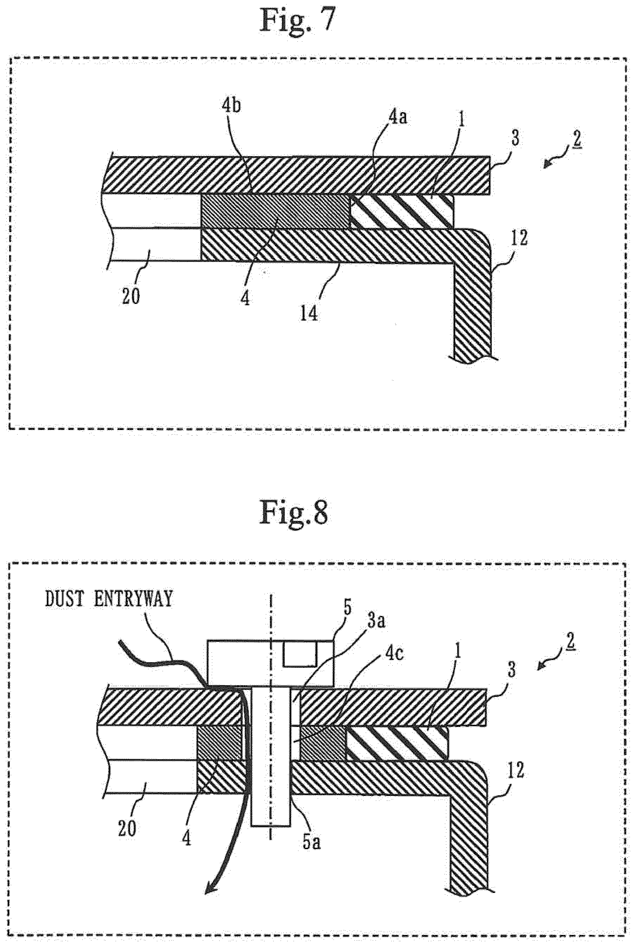

To solve this issue, a spacer 4 may be mounted on the surface where the packing is mounted, by welding or adhesion, as shown in FIG. 7.

In the structure of FIG. 7, the spacer 4 is used to provide a packing guide surface 4a for positioning the packing 1, and a cover contacting surface 4b prevents the packing 1 from being compressed excessively.

With respect to the structure in which the spacer 4 like the one in FIG. 7 is placed, the cover 3 is usually secured to the housing 2 by using securing screws 5, as shown in FIG. 8. The securing screw 5 is fastened to the female screw portion provided on a screw surface 5a in the housing 2 through a cover hole 3a and a spacer hole 4c.

Referring to the FIG. 8 structure, the packing 1 can greatly prevent dust outside from entering into the housing 2. However, since the screw surface 5a usually has a length corresponding to the thickness of one metal sheet, a tiny bit of dust entering through the screw surface 5a, indicated by the arrow (dust entryway) in FIG. 8, cannot be prevented sufficiently.

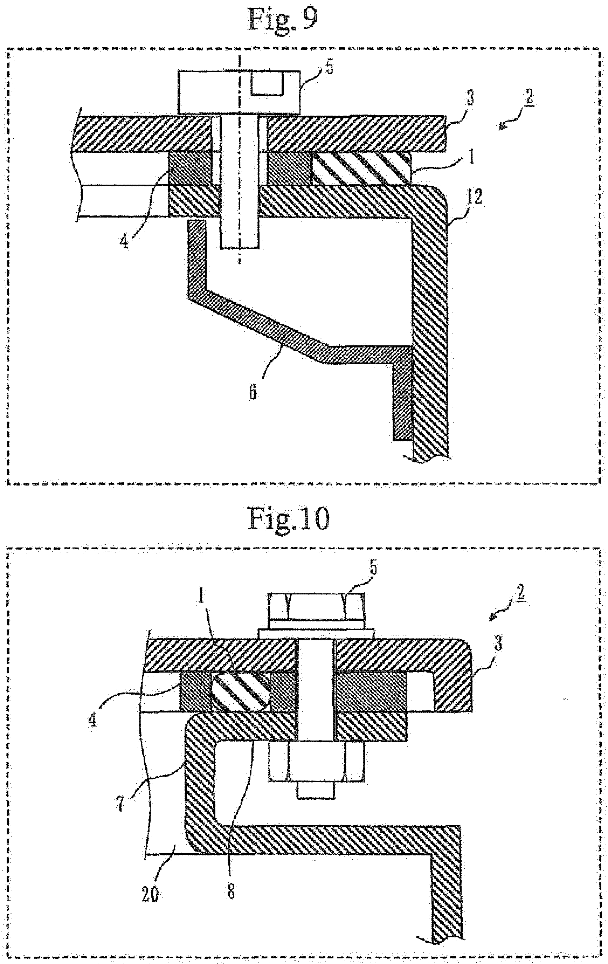

As disclosed in Patent Document 1 there is a method of providing a conduit 6 below the securing screw 5 inside the housing 2 (FIG. 9) as a structure to protect equipment in the housing from water and dust entering the housing through screw holes, for example.

The conduit 6 is usually fixed to the housing 2 by welding, adhesion or the like. The problem of the Patent Document 1 structure is that the number of parts required is increased, the amount of processing required for fixing the conduit 6 is increased, and the like.

As an existing structure to avoid dust and water entering by the influence of the securing screw 5, a structure like the one illustrated in FIG. 10 is given, in addition to the one in FIG. 9, for example.

FIG. 10 shows a waterproof structure disclosed in Patent Document 2, which has a neck portion 7 at the opening 20 of the housing 2, with a flange 8 extending outward from the periphery of the neck portion 7 so that the securing screw 5 does not protrude into the housing.

The structure of FIG. 10 is effective in positioning of the packing 1, in management of compression allowance, and in prevention of dust entering via the screw surface 5a. The problem is however that the forming processes and welding, connection, and other work of the neck portion 7 and the flange 8 are necessary, which results in higher costs.

### List of Citations

### Patent Literature

Patent Document 1: JP 2004-129 403 A
Patent Document 2: JP 2004-146 284 A

### Summary of the Invention

### Technical Problem

The conventional structures with the spacer provided at a portion where the packing is to be mounted in order to seal the opening of the plate housing, prevent the packing from not being uniformly mounted at the time of assembly, and from being compressed excessively.

To prevent dust entering through screw holes, however, extra parts are needed or a complex form needs to be created in the housing. The problem is that the number of parts required is thereby increased and so is the amount of processing for assembly.

It is a primary objective of this invention to solve problems such as those described above. The primary objective is to prevent dust from entering the housing via screw holes without an increase in the number of parts required and an increase in the amount of processing required for assembly.

### Solution to the Problem

A housing according to the present invention has a base plate, side plates and an opening which is provided on an opposite side of the base plate.

The housing may include:
a frame plate placed on the opposite side of the base plate, leading to the side plates and forming a frame of the opening; and
a spacer extending on the frame plate towards the opening, the spacer being folded back in the opening in side plate directions and fixed to inner surfaces of the side plates.

### Advantageous Effects of Invention

According to this invention, the spacer is folded back in the opening in the side plate directions, and fixed to the inner surfaces of the side plates. This allows the spacer to prevent dust from entering the housing through screw holes.

### Brief Description of the Drawings

- FIG. 1: is a perspective diagram illustrating an example of the structure of a housing according to a first embodiment.
- FIG. 2: is a diagram illustrating a cross-section A-A of the housing according to the first embodiment.
- FIG. 3: is a diagram illustrating a cross-section B-B of the housing according to the first embodiment.
- FIG. 4: is a diagram illustrating the cross-section A-A of the housing according to the fist embodiment.
- FIG. 5: is a perspective diagram illustrating an example of the structure of a conventional housing.
- FIG. 6: is a perspective diagram illustrating an example of the structure of a conventional housing.
- FIG. 7: is a perspective diagram illustrating an example of the structure of a conventional housing.
- FIG. 8: is a perspective diagram illustrating an example of the structure of a conventional housing.
- FIG. 9: is a perspective diagram illustrating an example of the structure of a conventional housing.
- FIG. 10: is a perspective diagram illustrating an example of the structure of a conventional housing.

### Description of Embodiments

### Embodiment 1.

In this embodiment, a hermetically sealed type plate housing is described to solve the problems discussed above.

The housing of this embodiment is provided with a spacer at the portion where a packing is to be mounted in the vicinity of an opening. The spacer is less thick than the packing to create a certain level difference between the packing and the spacer.

The spacer has a bent shape towards the inside of the housing.

The bent shape and the inner walls of the housing create an enclosed space in the housing. Securing screw holes through which securing screws are to be inserted communicate with the enclosed space via a cover and the spacer.

The level difference by the spacer serves to define the position of the packing to be mounted, and to regulate the compression on the packing.

The enclosed space created in the housing by the bent shape of the spacer and the inner walls of the housing can prevent dust entering through the securing screw holes from spreading throughout the housing.

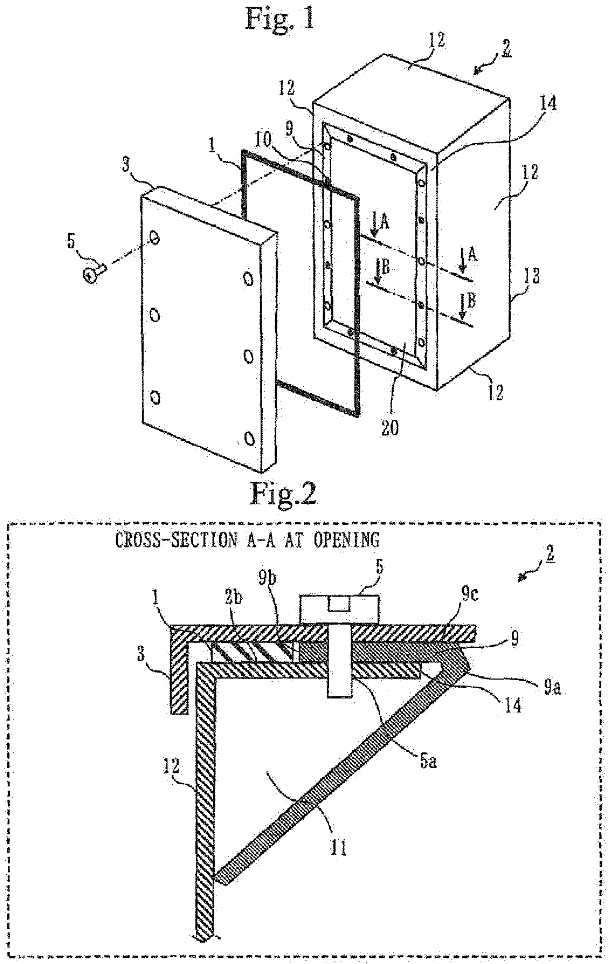

FIG. 1 is a drawing illustrating a perspective view of an example of the structure of a housing 2 according to this embodiment.

Referring to FIG. 1, the housing 2 has four side plates 12, a base plate 13, and a frame plate 14.

An opening 20 is provided on the opposite side of the base plate 13.

The frame plate 14 is placed on the opposite side of the base plate 13 to create a frame of the opening 20. The frame plate 14 leads to the four side plates 12.

On the frame plate 14, a spacer 9 is mounted.

The spacer 9 is a metal plate part, for example.

The frame plate 14 and the spacer 9 have securing screw holes through which securing screws 5 are to be inserted.

The securing screws 5 are screws for securing a cover 3 to the frame plate 14.

The frame plate 14 and the spacer 9 also have flat head screw holes through which flat head screws 10 are to be inserted.

The flat head screws 10 are screws for securing the spacer 9 to the frame plate 14.

Also on the frame plate 14, a packing 1 is mounted.

As described earlier, the spacer 9 serves to prevent the packing 1 from being compressed too much, and to define the position of the packing 1 to be mounted.

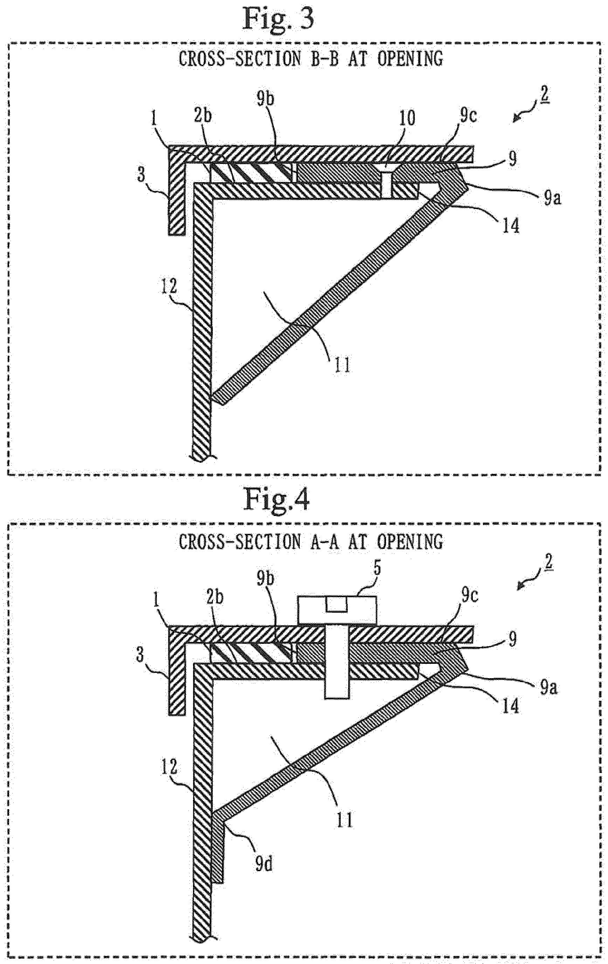

FIG. 2 is a diagram illustrating a cross-section A-A in FIG. 1. FIG. 3 is a diagram illustrating a cross-section B-B in FIG. 1.

As illustrated in FIGs. 2 and 3, the spacer 9 has a bent shape 9a.

Specifically, the spacer 9 extends on the frame plate 14 towards the opening 20, is folded back (bent shape 9a) in the opening 20 in the side plate 12 direction and is fixed to the inner wall of the side plate 12.

The bent shape 9a and the inner surfaces of the side plates 12 of the housing 2 create an enclosed space 11, and dust enters the enclosed space 11 passing through a screw surface 5a of the securing screw 5, thereby preventing dust from spreading throughout the housing 2.

An end surface of the spacer 9 serves as a guide for positioning the packing 1 to be mounted, as a packing guide surface 9b.

A cover contacting surface 9c is formed by the thickness of the spacer 9 at a position having a certain height over a packing mounting surface 2b.

The spacer 9 is shaped by cutting at an angle of 45° at the four corners of the frame plate 14 in FIG. 1 so that spacer 9 pieces do not interfere with each other.

In the structure illustrated in FIGs. 2 and 3, the spacer 9 has one bent shape 9a. Alternatively, another bent shape 9d may be provided at the other end of the spacer 9 as in FIG. 4.

Specifically, the other end of the spacer 9 may extend along the inner surfaces of the side plates 12.

The FIG. 4 structure, thus allowing the area of the spacer 9 contacting the inner surfaces of the housing 2 to be increased, has a greater effect in prevention of dust spreading.

The spacer 9 is described as a metal plate part, above. Alternatively, other than the metal plate part, any part made of resin or the like may be employed, instead.

A similar effect may be obtained if the spacer 9 is not the metal plate part.

In the example described above, the flat head screws 10 are used to secure the spacer 9 to the frame plate 14. Alternatively, welding or bonding may be used instead to secure the spacer 9 to the frame plate 14, which has a similar effect.

Thus, according to this embodiment, the mounting position of the packing may be defined, the packing may be prevented from being excessively compressed, and dust entering through screw holes may be prevented from spreading throughout the housing, without extra parts required other than the spacer. This allows the number of parts required to be reduced, overall material costs of the housing to be reduced, and the amount of processing required for assembly to be reduced, compared to when extra parts are added for dust protection.

### List of Reference Signs

- 1: packing
- 2: housing
- 2b: packing mounting surface
- 3: cover
- 3a: cover hole
- 4: spacer
- 4a: packing guide surface
- 4b: cover contacting surface
- 4c: spacer hole
- 5: securing screw
- 5a: screw surface
- 6: conduit
- 7: neck portion
- 8: flange
- 9: spacer
- 9a: bent shape
- 9b: packing guide surface
- 9c: cover contacting surface
- 9d: bent shape
- 11: enclosed space
- 12: side plate
- 13: base plate
- 14: frame plate
- 20: opening

## Claims

1. A housing having a base plate, side plates and an opening which is provided on an opposite side of the base plate, comprising:
- a frame plate placed on the opposite side of the base plate, leading to the side plates and forming a frame of the opening; and
- a spacer extending on the frame plate towards the opening, the spacer being folded back in the opening in side plate directions and fixed to inner surfaces of the side plates.

2. The housing of claim 1,
wherein:
the frame plate has a hole; and
the spacer has a hole which overlaps the hole of the frame plate.

3. The housing of claim 2,
wherein the frame plate and the spacer each have a hole which overlaps a hole in a cover when the cover with the hole covers the opening.

4. The housing of claim 1,
wherein the spacer extends along the inner surfaces of the side plates.

5. The housing of claim 1 further comprising a packing mounted on the frame plate with the spacer.

## Amended claims

### Amended claims under Art. 19.1 PCT

**1.** A housing having a base plate, side plates, and an opening which is provided on an opposite side of the base plate and covered by a cover with a screw hole, the housing comprising:
a frame plate placed on the opposite side of the base plate, leading to the side plates and forming a frame of the opening; and
a spacer extending on the frame plate towards the opening, the spacer being folded back in the opening in side plate directions and fixed to inner surfaces of the side plates;
wherein:
the spacer and the frame plate each have a screw hole;
the screw hole of the cover, the screw hole of the spacer and the screw hole of the frame plate overlap one another, and a securing screw is inserted through the screw holes overlapped of the cover, the spacer and the frame plate, so that the cover, the spacer and the frame plate are secured by the securing screw; and an enclosed space is created immediately below the overlapped screw holes of the cover, the spacer and the frame plate.

**4.** The housing of claim 1, wherein an end portion of the spacer extends along the inner surfaces of the side plates.

**5.** The housing of claim 1 further comprising a packing mounted on the frame plate with the spacer.

Statement under Art. 19.1 PCT
Claim 1 is amended based on the original claim 1 as filed and paragraphs [0014] to [0018] of the description of the present application. Claim 1 is amended in response to the adverse opinion of the International Search Report that "the subject matter of the original claim 1 and claim 5 exceeds the scope of the description of the detailed description of the invention".

Claim 4 corresponds to the original claim 4 as filed. Claim 4 is amended for consistency with the amended Claim 1.

The original claim 2 and claim 3 as filed are cancelled.
